# EUROPEAN PATENT APPLICATION

(11) **EP 2 161 761 A2**
(43) Date of publication of application: **10.03.2010**
(21) Application number: 09011498.4
(22) Date of filing: 08.09.2009
(51) Int. Cl.: H01L 31/12

(54) **Relay circuit**

(30) Priority: 09.09.2008 JP 2008230574
(71) Applicant: NEC Electronics Corporation, Kawasaki, Kanagawa 211-8668 (JP)
(72) Inventor: Minagawa, Tomohiro, Ohtsu-shi Shiga (JP)
(74) Representative: Glawe, Delfs, Moll

(57) **Abstract**

A relay circuit that includes: a light emitting element that outputs an optical signal in accordance with an input electric signal; a photoelectric conversion element that converts the optical signal into an electric signal and generates a potential difference between its opposite ends; a switching element that has a prescribed threshold value and that determines an output state in accordance with the potential difference that is generated by the photoelectric conversion element and that exceeds the prescribed value; first and second paths that are respectively connected to the opposite ends of the photoelectric conversion element and that transmit the potential difference generated by the photoelectric conversion element to the switching element; a discharge circuit that electrically connects the first path and the second path to each other when the potential difference generated by the photoelectric conversion element drops to a prescribed value; and a first resistor element that is arranged between the discharge circuit and the switching element and that is connected between the first path and the second path.

## Description

### BACKGROUND

### 1. Field of the Invention

The present invention relates to a relay circuit, and particularly to an optical semiconductor relay circuit.

### 2. Description of Related Art

In recent years, an accelerated increase in both capacity and speed of semiconductor devices necessitates semiconductor testers therefor that offer a shorter measurement time. As to optical semiconductor relays used in such semiconductor testers, important characteristics thereof are low capacitance, low on-resistance and high-speed operation. Low off-leakage current is another desired characteristic, because otherwise the off-leakage current may cause the semiconductor testers to malfunction.

As one means for realizing the high-speed operation characteristic of the optical semiconductor relays used in the semiconductor testers, a technique is proposed in Japanese Unexamined Patent Application Publication No. 2004-260047. Fig. 4 shows a circuit configuration of an optical semiconductor relay circuit 1 of Japanese Unexamined Patent Application Publication No. 2004-260047. As shown in Fig. 4, the optical semiconductor relay circuit 1 includes input terminals IN1 and IN2, output terminals OUT1 and OUT2, a light emitting element LED1, a light receiving element PD1, a discharge circuit 10, and MOSFETs (hereinafter referred to as MOS transistors) MN1 and MN2.

The light emitting element LED1 is connected between the input terminals IN1 and IN2. In accordance with an electric signal provided as a control signal between the input terminals IN1 and IN2, the light emitting element LED1 emits light.

The MOS transistors MN1 and MN2 are connected in series between the output terminals OUT1 and OUT2. The MOS transistors MN1 and MN2 function as relay switches that turn on/off external load circuitry (not shown) connected between the output terminals OUT1 and OUT2. The MOS transistor MN1 has its drain connected to the output terminal OUT1, its source connected to a node A, and its, gate connected to the discharge circuit 10. The MOS transistor MN2 has its drain connected to the output terminal OUT2 and its source connected to the node A. Thus, the MOS transistors MN1 and MN2 are connected in series, each having its source and drain oriented reversely relative to the others'. This configuration is employed because the optical semiconductor relay circuit, which is often in a state where an AC signal passes between the output terminals OUT1 and OUT2, must be so structured that a reverse-blocking state can be maintained bidirectionally for keeping the output terminals OUT1 and OUT2 electrically disconnected from each other.

The light receiving element PD1 has a photodiode array that receives light from the light emitting element LED1 and converts it into an electric signal. The plurality of photodiodes are connected in series between nodes C and E.

The discharge circuit 10 includes a resistor element R1, bipolar transistors T1 and T2, and diodes D1 and D2. The resistor element R1 is connected between the nodes C and E. The diode D1 has its anode connected to the node C and its cathode connected to a node B. The diode D2 has its anode connected to the node A and its cathode connected to the node E. The bipolar transistor T1 is a pnp transistor (hereinafter referred to as the pnp transistor T1). The pnp transistor T1 has its emitter connected to the node B, its collector connected to the node E, and its base connected to the node C. The bipolar transistor T2 is an npn transistor (hereinafter referred to as the npn transistor T2). The npn transistor T2 has its collector connected to the node C, its emitter connected to the node A, and its base connected to the node E. The pnp transistor T1 and the npn transistor T2 constitute a thyristor 11. The discharge circuit 10 has the function of quickly discharging carriers accumulated on the gates of the MOS transistors MN1 and MN2 so as to turn the MOS transistors MN1 and MN2 off.

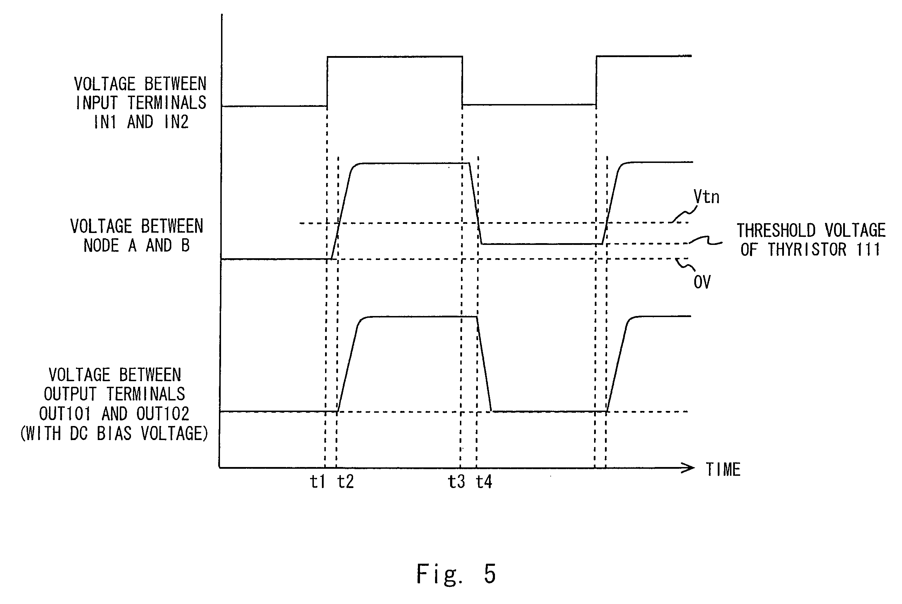

Referring to Fig. 5, the operation of the optical semiconductor relay circuit 1 will be described. Fig. 5 shows a state where a DC bias voltage is applied between the output terminals OUT1 and OUT2. Accordingly, when the output terminals OUT1 and OUT2 are electrically connected to each other, a voltage in accordance with the DC bias voltage is applied thereto.

First, at time point t1, an electric signal is provided as a control signal between the input terminals IN1 and IN2, and a current flows between the input terminals IN1 and IN2. As a result, the light emitting element LED1 emits light. The light enters the light receiving element PD1 within the same package, whereby a voltage is generated between the nodes C and E. As a result, a voltage is generated between the nodes A and B.

At time point t2, when the voltage between the nodes A and B exceeds a threshold value Vtn of the MOS transistors MN1 and MN2, the MOS transistors MN1 and MN2 enter an ON state. As a result, the output terminals OUT1 and OUT2 are electrically connected to each other (hereinafter, this state is referred to as a relay-turn-on state). At this time point, the thyristor 11 of the discharge circuit 10 is in an OFF state and the discharge operation is stopped.

Next, at time point t3, the supply of the electric signal between the input terminals IN1 and IN2 is stopped, and the supply of the current to the light emitting element LED1 is stopped. Accordingly, the light receiving element PD1 likewise stops generating the voltage between the nodes C and E. At this time point, the charges accumulated on the gates of the MOS transistors MN1 and MN2 are about to be discharged. However, since the diode D1 is connected in the reverse direction, only the leakage currents of the diode D1 and the thyristor 11 are discharged.

On the other hand, as the light emission of the light emitting element LED1 ceases, carrier recombination proceeds inside the photodiode array of the light receiving element PD1. Further, anode carriers are discharged via the resistor element R1. As a result, the anode potential of the photodiode array, i.e., the potential of the node C, drops faster than the gate potential of the MOS transistors MN1 and MN2, i.e., the potential of the node B, does.

At the time when the potential difference between the nodes C and B exceeds the threshold voltage of the thyristor 11, the thyristor 11 enters an ON state. Hence, the charges accumulated on the gates of the MOS transistors MN1 and MN2 are quickly discharged through the thyristor 11. At time point t4, the gate-source voltages of the MOS transistors MN1 and MN2 become lower than the threshold voltage Vtn of the MOS transistors. As a result, the MOS transistors MN1 and MN2 enter an OFF state. Thus, the output terminals OUT1 and OUT2 are electrically disconnected from each other (hereinafter, this state is referred to as a relay-turn-off state).

As described above, the optical semiconductor relay circuit 1 discharges the charges accumulated on the gates of the MOS transistors MN1 and MN2 through the discharge circuit 10 and, therefore, the optical semiconductor relay circuit 1 is advantageous in quickly achieving turn-off of the MOS transistors MN1 and MN2.

### SUMMARY

The present inventors have found a problem as follows. In the optical semiconductor relay circuit 1, after the light emission of the light emitting element LED1 ceases, the anode potential of the photodiode array of the light receiving element PD1 (i.e., the potential of the node C) drops. The potential difference between this anode potential and the gate potential of the MOS transistors MN1 and MN2 (i.e., the potential of the node B) becomes equal to or higher than the threshold voltage of thyristor 11, whereby the discharge circuit 10 starts the discharge operation. However, this discharge operation is stopped at the time when the potential difference between the nodes B and C becomes lower than the threshold voltage, e.g., about 0.6 V, of the thyristor 11. Accordingly, even in the relay-turn-off state, the voltage of about the threshold voltage of the thyristor 11, i.e., about 0.6 V, is still applied between the gate and source electrodes of the MOS transistors MN1 and MN2. Accordingly, in order to make the off-leakage current characteristic equivalent to that in a state where the gate and source of each of the MOS transistors MN1 and MN2 are shorted, it is necessary to design in advance the MOS transistors MN1 and MN2 to have threshold voltage Vtn that is higher by the threshold voltage of the thyristor 11, i.e., about 0.6 V. However, this involves the problem of increasing the on-resistance of the MOS transistors MN1 and MN2.

A first exemplary aspect of an embodiment of the present invention is a relay circuit comprising: a light emitting element that outputs an optical signal in accordance with an input electric signal; a photoelectric conversion element that converts the optical signal into an electric signal and generates a potential difference between its opposite ends; a switching element that has a prescribed threshold value and that determines an output state in accordance with the potential difference that is generated by the photoelectric conversion element and that exceeds the prescribed value; first and second paths that are respectively connected to the opposite ends of the photoelectric conversion element and that transmit the potential difference generated by the photoelectric conversion element to the switching element; a discharge circuit that electrically connects the first path and the second path to each other when the potential difference generated by the photoelectric conversion element drops to a prescribed value; and a first resistor element that is arranged between the discharge circuit and the switching element and that is connected between the first path and the second path.

Another exemplary aspect of an embodiment of the present invention is a relay circuit that controls an electrical connection state between a first output terminal and a second output terminal in accordance with an input electric signal, the relay circuit comprising: a light emitting element that outputs an optical signal in accordance with the input electric signal; a photoelectric conversion element that converts the optical signal into an electric signal; a transistor that has one terminal connected to the first output terminal and its other terminal connected to the second output terminal, and that is driven by a voltage that is in accordance with the electric signal and that is applied between its control terminal and the one terminal; a discharge circuit that includes a thyristor that electrically connects the control terminal and the one terminal of the transistor when the voltage in accordance with the electric signal drops to a prescribed value; and a first resistor element that is connected between the control terminal and the one terminal of the transistor.

The relay circuit according to the present invention is capable of electrically connecting a path and a second path to each other via a first resistor element, which cannot otherwise be electrically connected to each other until the first and second paths reach the same potential between the discharge circuit and the switching element. Thus, a switching element with a low-threshold voltage characteristic can be used at the output stage of the relay circuit.

The present invention can implement a relay circuit with a low on-resistance characteristic.

### BRIEF DESCRIPTION OF THE DRAWINGS

The above and other exemplary aspects, advantages and features will be more apparent from the following description of certain exemplary embodiments taken in conjunction with the accompanying drawings, in which:
Fig. 1 shows a configuration of an optical semiconductor relay circuit according to a first exemplary embodiment of the invention; and
Fig. 2 shows operational waveforms of the optical semiconductor relay circuit according to a first exemplary embodiment of the invention.
Fig. 3 shows a configuration of an optical semiconductor relay circuit according to a second exemplary embodiment of the invention; and

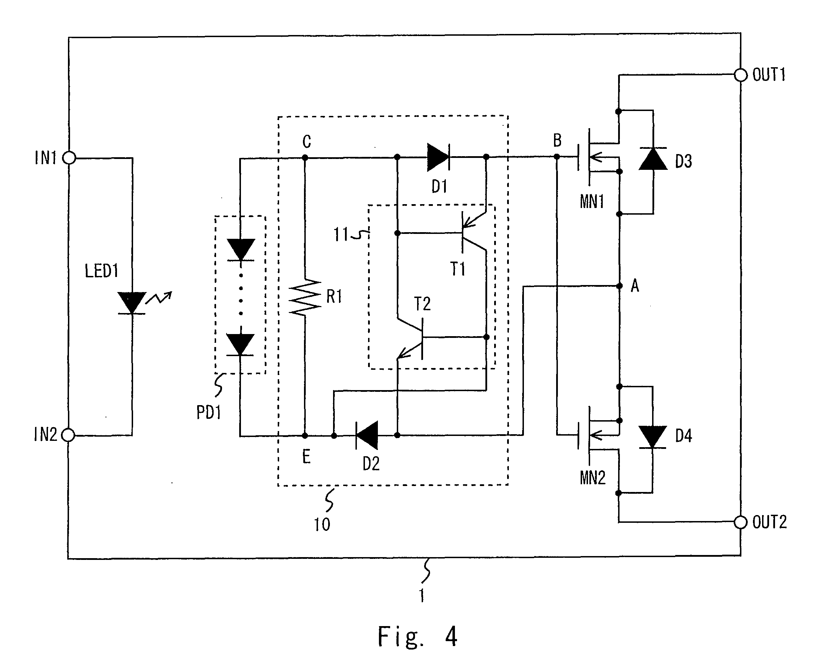

Fig. 4 shows a configuration of an optical semiconductor relay circuit according to a prior art; and
Fig. 5 shows operational waveforms of the optical semiconductor relay circuit according to the prior art.

### DETAILED DESCRIPTION OF THE EXEMPLARY EMBODIMENTS

### First Exemplary Embodiment

In the following, a first exemplary embodiment which is a specific embodiment to which the present invention is applied will be described in detail referring to the drawings. The first exemplary embodiment is an optical semiconductor relay circuit to which the present invention is applied.

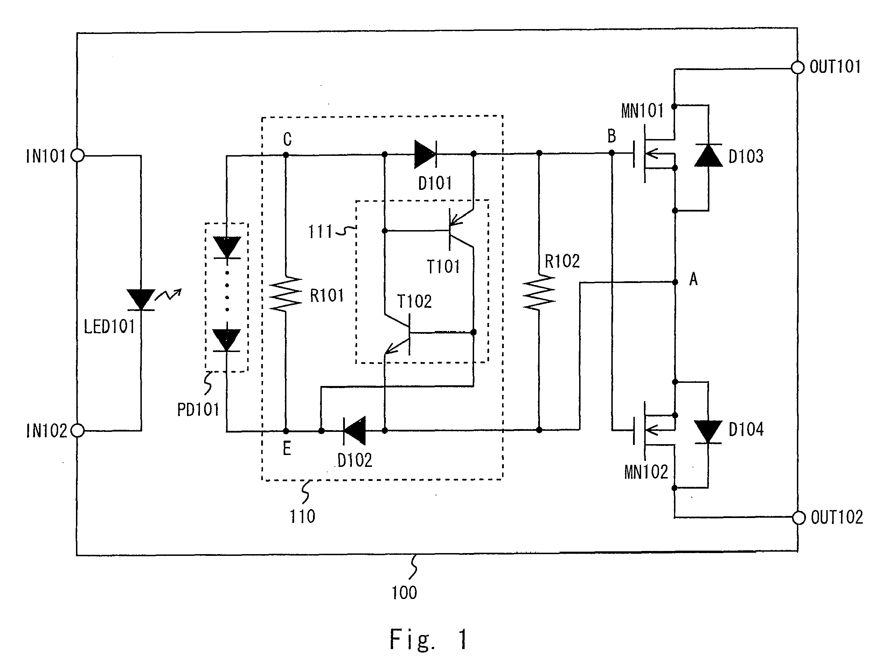

Fig. 1 shows an exemplary configuration of an optical semiconductor relay circuit 100 according to this exemplary embodiment. In the first exemplary embodiment, it is assumed that a DC bias voltage is applied between output terminals OUT101 and OUT102 that will be described later. As shown in Fig. 1, the optical semiconductor relay circuit 100 includes input terminals IN101 and IN102, the output terminals OUT101 and OUT102, a light emitting element LED101, a light receiving element PD101, a discharge circuit 110, MOSFETs (hereinafter referred to as MOS transistors) MN101 and MN102, and a resistor element R102.

The light emitting element LED101 is connected between the input terminals IN101 and IN102. The light emitting element LED101 is composed of a light emitting diode or the like, and emits light in accordance with an electric signal provided as a control signal between the input terminals IN101 and IN102.

The MOS transistors MN101 and MN102, which are NMOS transistors, are connected in series between the output terminals OUT101 and OUT102. The threshold voltage of the MOS transistors MN101 and MN102 is represented by Vtn. The MOS transistors MN101 and MN102 function as relay switching elements that turn on when the gate-source potential become equal to or higher than the threshold voltage Vtn to thereby electrically connect the output terminals OUT101 and OUT102.

The MOS transistor MN101 has its drain connected to the output terminal OUT101, its source connected to a node A, and its gate connected to a node B. A diode D103 is connected in parallel with the MOS transistor MN101. The diode D103 has its anode connected to the node A and its cathode connected to the output terminal OUT101.

The MOS transistor MN102 has its drain connected to the output terminal OUT102, its source connected to the node A, and its gate connected to the node B. A diode D104 is connected in parallel with the MOS transistor MN102. The diode D104 has its anode connected to the node A and its cathode connected to the output terminal OUT102.

Thus, the MOS transistors MN101 and MN102 are connected in series, each having its source and drain oriented reversely relative to the others'. This configuration is employed because the optical semiconductor relay circuit, which is often in a state where an AC signal passes between the output terminals OUT101 and OUT102, must be so structured that a reverse-blocking state can be maintained bidirectionally for keeping the output terminals OUT101 and OUT102 electrically disconnected from each other.

The light receiving element PD101 is a photoelectric conversion element that receives light from the light emitting element LED101 and converts it into an electric signal. The light receiving element PD101 has a photodiode array composed of a plurality of photodiodes. The photodiode array are connected in series so that each anode is arranged on the side of a node C and each cathode is arranged on the side of a node E.

The discharge circuit 110 includes a resistor element R101 (a second resistor element), bipolar transistors T101 and T102, and diodes D101 and D102. The resistor element R101 is connected between the nodes C and E. The diode D101 has its anode connected to the node C and its cathode connected to the node B. The diode D102 has its anode connected to the node A and its cathode connected to the node E. The bipolar transistor T101 is a pnp transistor (hereinafter referred to as the pnp transistor T101). The pnp transistor T101 has its emitter connected to the node B, its collector connected to the node E, and its base connected to the node C. The bipolar transistor T102 is an npn transistor (hereinafter referred to as the npn transistor T102). The npn transistor T102 has its collector connected to the node C, its emitter connected to the node A, and its base connected to the node E. The pnp transistor T101 and the npn transistor T102 constitute a thyristor 111. The threshold voltage of the thyristor 111 is, for example, about 0.6V. The discharge circuit 110 has the function of quickly discharging carriers accumulated on the gates of the MOS transistors MN101 and MN102 so as to turn the MOS transistors MN101 and MN102 off.

The anode of the light receiving element PD101 (the node C) and the gates of the MOS transistors MN101 and MN102 (the node B) are connected via the diode D101. This line is defined as a first path. On the other hand, the sources of the MOS transistors MN101 and MN102 (the node A) and the cathode of the light receiving element PD101 (the node E) are connected via the diode D102. This line is defined as a second path.

The resistor element R102 (first resistor element) is connected between the nodes B and A. The resistance value of the resistor element R102 should desirably satisfy the relationship R102>R101 so that the anode potential of the photodiode array of the light receiving element PD101 drops faster than the gate potential of the MOS transistors MN101 and MN102 does. These resistor elements R101 and R102 for the discharge operation have high resistance values, ranging from several MΩ to several hundred MΩ, e.g., R101=50MΩ and R102=30MΩ. Therefore, insertion of the resistor elements has little effect on the relay-turn-on time. It should be noted that, for the sake of convenience, the reference characters "R101" and "R102" represent not only the name of the resistor elements but also their resistance values.

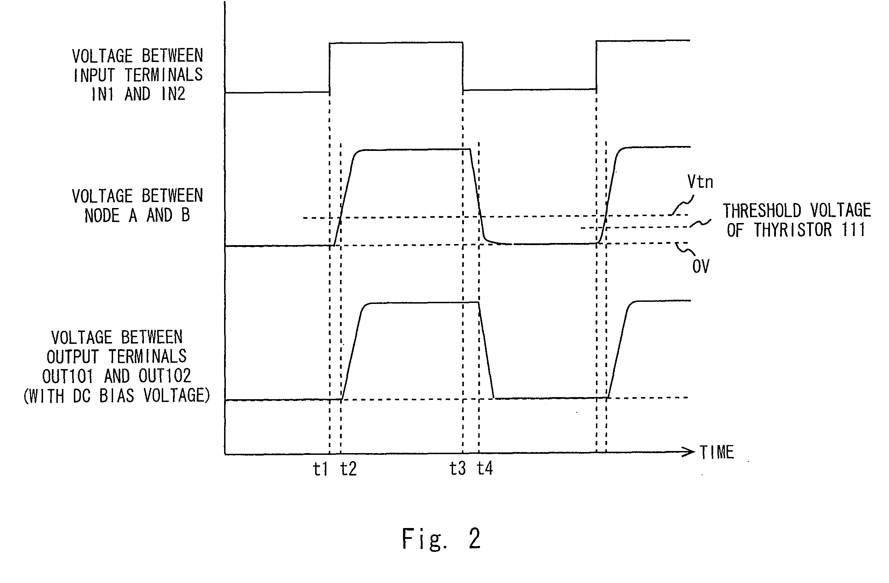

Referring to Fig. 2, the operation of the above-described optical semiconductor relay circuit 100 will be described. Fig. 2 shows a state where the DC bias voltage is applied between the output terminals OUT101 and OUT102. Accordingly, when the output terminals OUT101 and OUT102 are electrically connected to each other, a voltage in accordance with the DC bias voltage is applied between the output terminals OUT101 and OUT102.

First, at time point t1, an electric signal is provided as a control signal between the input terminals IN101 and IN102, and a current flows between the input terminals IN101 and IN102. As a result, the light emitting element LED101 emits light. The light enters the light receiving element PD101 within the same package, whereby a voltage is generated between the nodes C and E. As a result, a voltage is generated between the nodes A and B.

At time point t2, when the voltage between the nodes A and B exceeds the threshold value Vtn of the MOS transistors MN101 and MN102, the MOS transistors MN101 and MN102 enter an ON state. As a result, the output terminals OUT101 and OUT102 are electrically connected to each other, becoming a relay-turn-on state. At this time point, the thyristor 111 of the discharge circuit 110 is in an OFF state and the discharge operation of the discharge circuit 110 is stopped.

Next, at time point t3, the supply of the electric signal between the input terminals IN101 and IN102 is stopped, and the supply of the current to the light emitting element LED101 is stopped. Accordingly, the light emission of the light emitting element LED101 ceases, and the voltage generation between the nodes C and E by the light receiving element PD101 also ceases.

As the light emission of the light emitting element LED101 ceases, carrier recombination proceeds inside the photodiode array of the light receiving element PD101. Further, anode carriers are discharged via the resistor element R101. On the other hand, discharge of the charges accumulated on the gates of the MOS transistors MN101 and MN102 starts via the resistor element R101. It is to be noted that the anode potential of the photodiode array, i.e. , the potential of the node C, drops faster than the gate potential of the MOS transistors MN101 and MN102, i.e., the potential of the node B, does.

At the time when the potential difference between the nodes C and B exceeds the threshold voltage of the thyristor 111, the thyristor 111 enters an ON state. Hence, the charges accumulated on the gates of the MOS transistors MN101 and MN102 are quickly discharged through the thyristor 111. At time point t4, the gate-source voltages of the MOS transistors MN101 and MN102 become lower than the threshold voltage Vtn of the MOS transistors. As a result, the MOS transistors MN101 and MN102 enter an OFF state. Thus, the output terminals OUT101 and OUT102 are electrically disconnected from each other, becoming a relay-turn-off state. Further, when the potential difference between the nodes C and B becomes lower than about 0.6 V which is the threshold voltage of the thyristor 111, the thyristor 111 enters an OFF state. However, even after the thyristor 111 is turned off, discharge of the gate charges of the MOS transistors MN101 and MN102 continues via the discharge resistor R102. Therefore, the gate-source voltages drop approximately to a ground voltage GND.

Here, in the conventional optical semiconductor relay circuit 1, the charges accumulated on the gates of the MOS transistors MN1 and MN2 are similarly discharged through the thyristor 11 in a relay-turn-off operation. The conventional circuit, however, involves the following problem. First, the potential difference between the gate potential of the MOS transistors MN1 and MN2 and the anode potential of the photodiode array of the light receiving element PD1 becomes lower than the threshold voltage (about 0.6 V) of the thyristor 11 and the thyristor enters an OFF state. At this time point, the discharge paths of the charges accumulated on the gates of the MOS transistors MN1 and MN2 are only extremely small leakage current paths, such as the gate-source leakage currents via the gate oxide films of the MOS transistors and the thyristor off-leakage current via the thyristor 11. Accordingly, the gate charges are hardly discharged and the gate-source voltages of the MOS transistors MN1 and MN2 are maintained in a state where a voltage around the threshold voltage of the thyristor 11 (about 0.6 V) is applied. This causes an increase in both the off-leakage current in the relay-turn-off state and the on-resistance in the relay-turn-on state.

In the optical semiconductor relay circuit 100 of the first exemplary embodiment of the invention, the resistor element R102 is connected in parallel between the gates and sources (between the nodes B and A). This discharge resistor R102 is used as a discharge path for the gate charges of the MOS transistors MN101 and MN102 after the thyristor 111 turns off. As described above, the gate charges of the MOS transistors MN101 and MN102 after the turn-off of the thyristor 111 causes an increase in both the off-leakage current and the on-resistance. In contrast, the optical semiconductor relay circuit 100 of the first exemplary embodiment of the invention allows the gate charges of the MOS transistors MN101 and MN102 to be discharged even after the turn-off of the thyristor 111. Hence, it becomes possible to set lower threshold voltage of the MOS transistors MN101 and MN102 without causing an increase in the off-leakage current. This realizes reduced on-resistance characteristic of the MOS transistors MN101 and MN102. It should be noted that, in using the resistor element R102, the circuit must be so designed that the gate potential of the MOS transistors MN101 and MN102 does not drop faster than the anode potential of the photodiode array of the light receiving element PD101 does in the relay-turn-off operation. If the gate potential of the MOS transistors MN101 and MN102 drops faster than the anode potential of the photodiode array does, the thyristor 111 of the discharge circuit 110 will not operate and the turn-off time of the thyristor 111 will extremely be delayed.

### Second exemplary Embodiment

In the following, a second exemplary embodiment which is a specific embodiment to which the present invention is applied will be described in detail referring to the drawings. Similarly to the first exemplary embodiment, the second exemplary embodiment of the invention is an optical semiconductor relay circuit to which the present invention is applied.

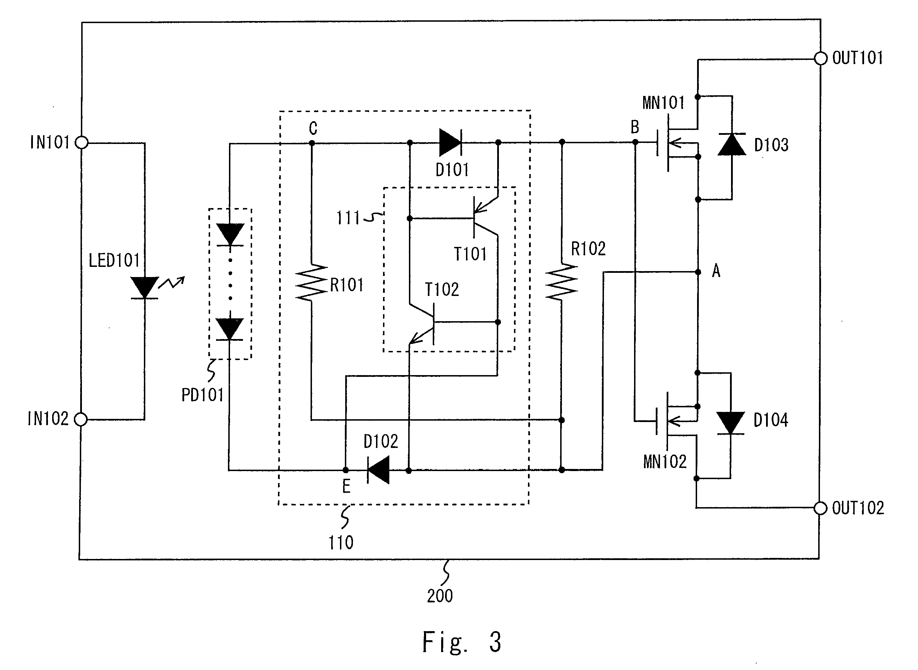

Fig. 3 shows an exemplary configuration of an optical semiconductor relay circuit 200 according to this exemplary embodiment. As shown in Fig. 3, the optical semiconductor relay circuit 200 includes input terminals IN101 and IN102, output terminals OUT101 and OUT102, a light emitting element LED101, a light receiving element PD101, a discharge circuit 110, MOS transistors MN101 and MN102, and a resistor element R102. Of the reference signs affixed in the drawing, the same reference signs as in Fig. 1 denote the identical or similar constituents as in Fig. 1. The difference from the first exemplary embodiment is only the way of connection for the resistor element R101. Accordingly, description will be given in the second exemplary embodiment focusing on this difference. As the rest of the configuration is the same as the optical semiconductor relay circuit 100 of the first exemplary embodiment, the description thereof will be omitted.

The resistor element R101 is connected between the nodes C and A. As the operational waveforms of the optical semiconductor relay circuit 200 of the second exemplary embodiment of the invention is the same as those in Fig. 2, the description thereof will be omitted.

In the optical semiconductor relay circuit 200 of the second exemplary embodiment of the invention, the resistor elements R102 and R101 are shorted to the sources of the MOS transistors MN101 and MN102, i.e., the node A. Accordingly, with the optical semiconductor relay circuit 200, the thyristor operation in the relay-turn-off mode can further be ensured as compared with the optical semiconductor relay circuit 100 of the first exemplary embodiment.

The present invention is not limited to the above-described embodiments and can be modified as appropriate so long as it is consistent with the purpose of the present invention. For example, while the gates of the MOS transistors MN101 and MN102 are both connected to the node B in the first and second exemplary embodiments, two systems each including the light receiving element PD101 and the discharge circuit 110 may be prepared so that the circuits of two systems respectively drive the MOS transistors MN101 and MN102. The optical semiconductor relay circuit having such a configuration will achieve an operation with high-frequency signals, in addition to the effects according to the first and second exemplary embodiments described above.

Further, while the two MOS transistors (the MOS transistors MN101 and MN102) are included in the first and second exemplary embodiments, the number of the MOS transistor connected between the output terminals OUT101 and OUT102 may be one. Still further, the MOS transistors may be replaced by bipolar transistors.

While the invention has been described in terms of several exemplary embodiments, those skilled in the art will recognize that the invention can be practiced with various modifications within the spirit and scope of the appended claims and the invention is not limited to the examples described above.

Further, the scope of the claims is not limited by the exemplary embodiments described above.

Furthermore, it is noted that, Applicant's intent is to encompass equivalents of all claim elements, even if amended later during prosecution.

## Claims

1. A relay circuit comprising:
a light emitting element that outputs an optical signal in accordance with an input electric signal;
a photoelectric conversion element that converts the optical signal into an electric signal and generates a potential difference between both ends;
a switching element having a prescribed threshold value, the switching element being configured to determine an output state in accordance with the potential difference that is generated by the photoelectric conversion element and is lager than the prescribed threshold value;
first and second paths respectively connected to the both ends of the photoelectric conversion element, the first and second paths being configured to transmit the potential difference generated by the photoelectric conversion element to the switching element;
a discharge circuit that electrically connects the first path and the second path to each other when the potential difference generated by the photoelectric conversion element drops to a prescribed value; and
a first resistor element arranged between the discharge circuit and the switching element, the first resistor being between the first path and the second path.

2. The relay circuit according to Claim 1, wherein the switching element comprises a transistor having a control terminal connected to the first path and a first terminal connected to the second path.

3. The relay circuit according to Claim 2, wherein the transistor is an MOS transistor that having a gate connected to the first path and a source connected to the second path.

4. The relay circuit according to Claim 1, wherein
the discharge circuit comprises:
a first diode arranged on the first path;
a second diode arranged on the second path;
a four-terminal thyristor that having an anode connected to the first path between the first diode and the switching element, a cathode connected to the second path between the second diode and the switching element, a first gate connected to the first path between the first diode and the photoelectric conversion element, and a second gate connected to the second path between the second diode and the photoelectric conversion element; and
a second resistor element that having one terminal connected to the first path between the first diode and the photoelectric conversion element, and another terminal connected to the second path between the second diode and the photoelectric conversion element.

5. The relay circuit according to Claim 1, wherein
the discharge circuit comprises:
a first diode arranged on the first path;
a second diode arranged on the second path;
a four-terminal thyristor that having an anode connected to the first path between the first diode and the switching element, a cathode connected to the second path between the second diode and the switching element, a first gate connected to the first path between the first diode and the photoelectric conversion element, and a second gate connected to the second path between the second diode and the photoelectric conversion element; and
a second resistor element having one terminal connected to the first path between the first diode and the photoelectric conversion element, and another terminal connected to the second path between the second diode and the switching element.

6. The relay circuit according to Claim 4, wherein a resistance value of the first resistor element is greater than a resistance value of the second resistor element.

7. A relay circuit that controls an electrical connection state between a first output terminal and a second output terminal in accordance with an input electric signal, the relay circuit comprising:
a light emitting element that outputs an optical signal in accordance with the input electric signal;
a photoelectric conversion element that converts the optical signal into an electric signal;
a transistor that having terminal connected to the first output terminal and another terminal connected to the second output terminal, the transistor being driven by a voltage in accordance with an electric signal applied between a control terminal and another terminal;
a discharge circuit that comprising a thyristor that electrically connects the control terminal and the one terminal of the transistor when the voltage in accordance with the electric signal drops to a prescribed value; and
a first resistor element connected between the control terminal and the one terminal of the transistor.

8. The relay circuit according to Claim 7, wherein
the discharge circuit further comprises:
a first diode having an anode connected to one terminal of the photoelectric conversion element and a cathode connected to the control terminal of the transistor;
a second diode that having a cathode connected to the another terminal of the photoelectric conversion element and an anode connected to the one terminal of the transistor; and
a second resistor element connected between the one terminal and the another terminal of the photoelectric conversion element, and
wherein the thyristor is a four-terminal thyristor that having an anode connected to the control terminal of the transistor, a cathode connected to the one terminal of the transistor, an N gate connected to the one terminal of the photoelectric conversion element, and a P gate connected to the another terminal of the photoelectric conversion element.

9. The relay circuit according to Claim 8, wherein a resistance value of the first resistor element is greater than a resistance value of the second resistor element.

10. The relay circuit according to Claim 7, wherein
the discharge circuit further comprises:
a first diode that having an anode connected to one terminal of the photoelectric conversion element and a cathode connected to the control terminal of the transistor;
a second diode that having a cathode connected to the another terminal of the photoelectric conversion element and an anode connected to the one terminal of the transistor; and
a second resistor element connected between the one terminal of the photoelectric conversion element and the one terminal of the transistor, and
wherein the thyristor is a four-terminal thyristor that having an anode connected to the control terminal of the transistor, a cathode connected to the one terminal of the transistor, an N gate connected to the one terminal of the photoelectric conversion element, and a P gate connected to the another terminal of the photoelectric conversion element.

11. The relay circuit according to Claim 10, wherein a resistance value of the first resistor element is greater than a resistance value of the second resistor element.
